Europäisches Patentamt

European Patent Office

Office européen des brevets

(11) Publication number: **0 020 784**
**B1**

(12) **EUROPEAN PATENT SPECIFICATION**

(45) Date of publication of patent specification: **08.08.84**

(21) Application number: **80900063.1**

(22) Date of filing: **12.12.79**

(86) International application number:
**PCT/JP79/00314**

(87) International publication number:
**WO 80/01330 26.06.80 Gazette 80/14**

(51) Int. Cl.³: **H 01 G 13/00,**
**H 01 C 17/28, B 21 F 21/00**

(54) **LEAD WIRE FORMING APPARATUS FOR ELECTRICAL PARTS.**

(30) Priority: **20.12.78 JP 159758/78**

(43) Date of publication of application:
**07.01.81 Bulletin 81/1**

(45) Publication of the grant of the patent:
**08.08.84 Bulletin 84/32**

(84) Designated Contracting States:
**DE FR GB**

(56) References cited:
**JP - A - 49 123 967**
**JP - B - 41 016 338**
**JP - B - 50 036 431**
**US - A - 3 796 210**

(73) Proprietor: **Matsushita Electric Industrial Co., Ltd.**
**1006, Oaza Kadoma**
**Kadoma-shi Osaka-fu, 571 (JP)**

(72) Inventor: **KINOSHITA, Hiromi**
**4925-5, Oaza Hoshida**
**Katano-shi Osaka-fu 576 (JP)**
Inventor: **MAEDA, Yoshinobu**
**15-17, Myokenzaka 3-chome**
**katano-shi Osaka-fu 576 (JP)**
Inventor: **Tanno, Tadashi**
**25-3, Mido-cho**
**Kadoma-shi Osaka-fu 571 (JP)**

(74) Representative: **Crawford, Andrew Birkby et al,**
**A.A. THORNTON & CO. Northumberland House**
**303-306 High Holborn**
**London WC1V 7LE (GB)**

Courier Press, Leamington Spa, England.

## Description

This invention relates to an apparatus for bending the lead wires of electrical parts have a body member and a pair of the lead wires extended co-axially in opposite directions from the body member and being, for example, previously disposed on a tape at equal intervals.

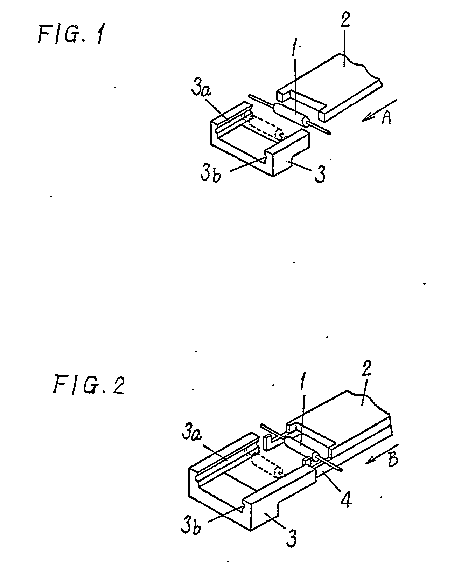

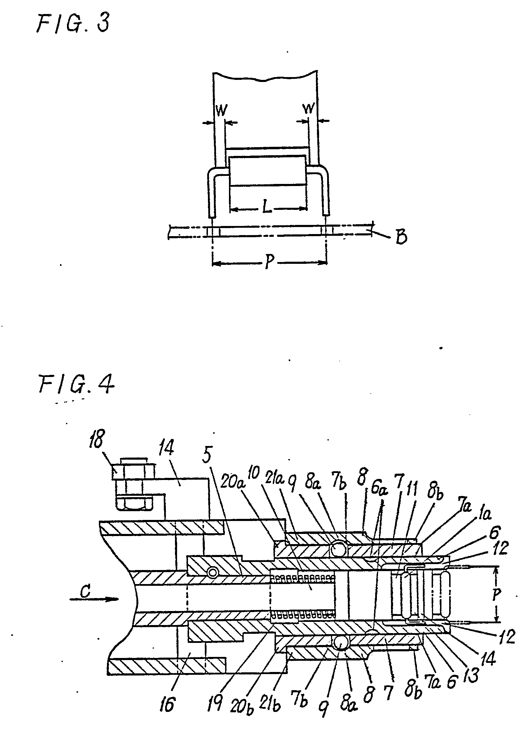

Prior lead wire forming methods may be divided into two types. According to a first method such as that disclosed in Japanese Patent No. 41—16338 and as shown in Figure 1, the lead wires of an electrical part 1 are pushed by a pushing means 2 in a direction indicated by arrow A, so that they are forced into a pair of lead wire grooves 3a, 3b of a forming means 3 to be formed and held therein. According to a second method as shown in Figure 2, a pushing means 3 moves in a direction indicated by arrow B, so that the lead wires of an electric part are forced into lead wire grooves 3a, 3b while being held between a lever 4 and the pushing means 2. With such methods, however, in order to bend the lead wires and as shown in Figure 3, the width W of the contact portion of the pushing means is necessarily added to the length L of a body member of an electrical part thereby increasing the insertion pitch P on a printed circuit board. Therefore, a large space is required for each part to be mounted on a printed circuit board, thereby giving the drawback that the printed circuit board is large and costly. Moreover the lead wires may be damaged due to the action between the pushing means 2 and the forming means 3.

A further method is disclosed in Japanese Patent No. 49—123,967 in which lead wires of an electrical part are fed into V-shaped grooves formed on support blocks. After receiving the lead wires the support blocks are lowered to a lead wire forming die. A slider is horizontally moved so that a presser presses the electrical part against the fixed lead wire forming die. As the slider further advances the lead wires are cut by cutters at which point the slider stops. The support blocks are further lowered so that the lead wires are disengaged from the V-shaped grooves. As the slider advances again, lead wire benders bend the lead wires where they protrude from the electric part while the electrical part is held between the presser and the die.

The present invention provides apparatus for bending the lead wires of an electrical part, which lead wires extend co-axially in opposite directions from a body member comprising means for gripping the body of the electrical part, forming members spaced apart by a distance slightly larger than the length of the body member, and means for causing relative movement between the electrical part and the forming members whereby to bend the lead wires in the same direction and perpendicular to their original direction, characterised in that the forming members are provided with grooves in the interior walls thereof for receiving the lead wires when forced therein by the means, and in that one of said pair of members is arranged to be movable between a first position where it co-operates with the other member to grip the body member of the electrical part and retain it against movement in a direction (C) parallel to the direction of relative movement between the part and the forming members and a second position where it does not grip the body member and permits movement in said direction.

In order that the present invention be more readily understood an embodiment thereof will now be described by way of example with reference to the accompanying drawings, in which:—

Figure 1 and Figure 2 show fragmentary perspective view of prior art forming apparatus;

Figure 3 shows a diagrammatic front view for explaining the disadvantages of the prior art;

Figure 4 shows a sectional plan view of the principal portion of a forming apparatus according to one embodiment of this invention in a first position;

Figure 5 shows a sectional plan view of a part of the apparatus shown in Figure 4 in a second position;

Figure 6 shows a sectional side view of the apparatus shown in Figure 4; and

Figure 7 shows an enlarged sectional plane view of a detail of the apparatus shown in Figure 4.

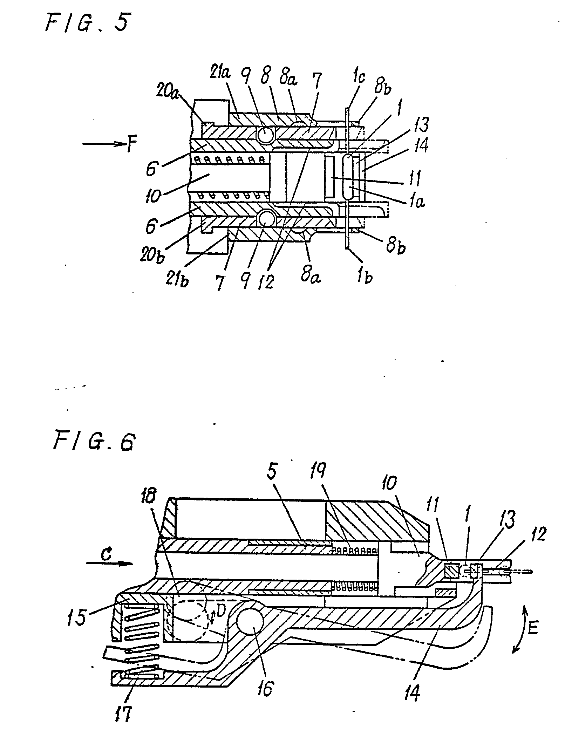

Referring now to Figures 4 and 5, apparatus for bending the lead wires of electrical parts comprises a piston 5 which is slidable in a direction indicated by arrow C in Figure 4 and to a top portion of which forming guides 6 are attached. Cutters 7 which are provided with cutter blades 7a, are slidably mounted on both exterior walls of the forming guides 6 and slide relatively to stationary cutters 8 located on the outer side therof to cut off lead wires 1b, 1c, of an electrical part 1. Curring blades 8b are formed on the top portion of the stationary cutters 8. The cutters 7 are guided by the stationary cutters 8. Balls 9 are received in holes 7b formed in the cutters 7 so that the forming guides 6 and cutters 7 can move together. Engaging grooves 6a for the balls 9 are formed in the forming guides 6. A pusher 10 is slidably fitted lengthwise into the piston 5 and the forming guides 6. A resilient member 11 is attached to the end of the pusher 10 and the pusher 10 is coupled through a compression spring 19 to the end of the piston 5. Guiding grooves 12 are formed in the interior walls of the forming guides 6 for receiving and guiding the lead wires 1b, 1c and the distance between the guiding grooves 12 is only slightly larger than the length of the body member 1a of the electrical part 1. Another resilient member 13 is attached to a lever 14 which is rotatably pivoted by a pin 16 to a base member 15. The lever 14 is rotated by movement of a roller 18 in the direction indicated by arrow D in Figure 6 and biased in the counter-clockwise direction in Figure 6 by a spring 17 to locate the resilient member 13 opposite the resilient member 11 and thereby grip the body member 1a of an electrical part 1 therebetween.

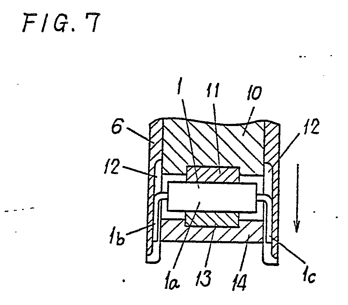

The operation of the above construction will now be explained. Referring to Figure 5, after an electrical part is fed to the predetermined position, the piston 5 (Figures 4, 6) and the forming guides 6 are advanced by air pressure in the direction indicated by arrow F. Simultaneously the pusher 10 fitted into the inner space of the forming guide 6 is advanced in the same direction F under the force of the compression spring 19. Since the cutters 7 are coupled to the forming guides 6 by the balls 9 the cutters and forming guides advance together in the same direction F. Consequently, the body member 1a of an electrical part 1 is gripped between the resilient member 11 attached to the end of the pusher 10 and the resilient member 13 attached to the lever 14. At this time, the pusher 10 stops its advance because the compression spring 17 biasing the lever 14 is stronger than the compression spring 19 biasing the pusher 10. Nevertheless, the piston 5 is further advanced by the air pressure against the force of the compression spring 19, so that the cutting blades 7a of the cutters 7 cooperate with the cutting blades 8b of the stationary cutter 8 to cut off the excess portions of the lead wires 1b, 1c of the part 1. After cutting off, the piston 5 is further advanced until projections 20a, 20b of the cutters 7 reach stops 21a, 21b of the stationary cutters 8. In this position, the balls 9 are adapted to be forced into engaging grooves 8a formed in the stationary cutters 8 by continued movement of the forming guides 6 which now move relative to the cutters 7 so that only the forming guides 6 are further advanced until the piston 5 reaches the end of the cylinder (Figure 4). Meanwhile, the cut off lead wires 1b, 1c of the parts 1 are bent and fitted into the guiding grooves 12 of the forming guide 6 through movement of the forming guide 6 relative to the cut off lead wires of the part 1 whose body member 1a is held between the resilient parts 11, 13 by the lever 14 (Figure 7). Then, the roller 18 is pushed by a block (not shown) so that the lever 14 is caused to rotate in the clockwise direction in Figure 6 to disengage the resilient part 13 from supporting the electric part 1 and enable movement of the electric part 1 in the direction indicated by arrow C. Accordingly, the electric part 1 is pushed along the guiding grooves 12 by the resilient member 11 and the pusher 10 in the direction indicated by arrow C in Figure 4 under the force of the compression spring 19, already compressed, so that the electric part 1 is inserted into apertures in a printed circuit board (not shown).

According to the lead wire forming apparatus described above, by means of forming methods dimensionally based on the body member of an electric part, damage to the electrical parts by gripping the lead wires may be eliminated. Further, the pitch for forming or inserting the parts on a printed circuit board can be reduced to substantially that of the length of the body member of the electric part, thereby reducing the space electric parts occupy on a printed circuit board. This results in a smaller printed circuit board with consequent cost reduction.

## Claims

1. Apparatus for bending the lead wires (1b, 1c) of an electrical part (1), which lead wires extend co-axially in opposite directions from a body member (1a) comprising means (17, 14, 13, 11) for gripping the body (1a) of the electrical part (1), forming members (6) spaced apart by a distance slightly larger than the length of the body member (1a), and means (5) for causing relative movement between the electrical part (1) and the forming members (6) whereby to bend the lead wires in the same direction and perpendicular to their original direction, characterised in that the forming members (6) are provided with grooves (12) in the interior walls thereof for receiving the lead wires when forced therein by the means (5), and in that one (13) of said pair of members (11, 13) is arranged to be movable between a first position where it co-operates with the other member (11) to grip the body member (1a) of the electrical part (1) and retain it against movement in a direction (C) parallel to the direction of relative movement between the part (1) and the forming members (6) and a second position where it does not grip the body member (1a) and permits movement in said direction (C).

2. Apparatus according to claim 1, wherein the other (11) of said pair of members (11, 13) is arranged to be movable in said direction (C).

3. Apparatus according to claim 2, wherein the other (11) of said pair of members (11, 13) is provided on the end of a piston member (5) which is biased by a spring (19) to move in said direction (C) when said one (13) of said pair of members is moved to its second position whereby to push the electrical part from the apparatus.

## Patentansprüche

1. Vorrichtung zum Biegen von Anschlußdrähten (1b, 1c) eines elektrischen Bauteils (1), wobei die Anschlußdrähte sich von einem Körperelement (1a) koaxial in entgegengesetzte Richtungen erstrecken, mit Mitteln (17, 14, 13, 11) zum Halten des Körpers (1a) des elektrischen Bauteils (1), mit Formelementen (6), die mit einem gegenseitigen Abstand, der etwas größer als die Länge des Körperelements (1a) ist, angeordnet sind, und mit Mitteln (5) zum Bewirken einer relativen Bewegung zwischen dem elektrischen Bauteil (1) und den Formelementen (6), um somit die Anschlußdrähte in die gleiche Richtung und senkrecht zu ihrer ursprünglichen Richtung umzubiegen, dadurch gekennzeichnet, daß die Formelemente (6) in ihren Innenwänden Rillen (12) zum Aufnehmen der durch die Mittel (5) in die Rillen (12) hineingezwungenen Anschlußdrähte aufweisen, und daß eines (13) der beiden genannten Elemente (11, 13) zur Bewegung zwischen einer ersten Position und einer zweiten Position angeordnet ist, wobei es in der ersten Position mit dem anderen Element (11) zusammenwirkt, um das Körperelement (1a) des elektrischen Bauteils (1) zu halten und dieses von einer Bewegung in eine Richtung (C) parallel zur Richtung der relativen Bewegung zwischen dem Bauteil (1) und den Formelementen (6) zurückzuhalten und wobei es in der zweiten Position das Körperelement (1a) nicht hält und Bewegung in die genannte Richtung (C) zuläßt.

2. Vorrichtung nach Anspruch 1, in welcher das andere (11) der beiden Elemente (11, 13) zur Bewegung in die genannte Richtung (C) angeordnet ist.

3. Vorrichtung nach Anspruch 2, in welcher das andere (11) der beiden Elemente (11, 13) an dem Ende eines Kolbenelementes (5) vorgesehen ist, welches durch eine Feder (19) beaufschlagt ist, sich in die genannte Richtung (C) zu bewegen, wenn das genannte eine (13) der beiden Elemente in seine zweite Position bewegt wird, wobei der elektrische Bauteil von der Vorrichtung abgestoßen wird.

### Revendications

1. Appareil permettant de fléchir les fils conducteurs (1b, 1c) d'une pièce électrique (1), lesquels fils électriques s'étendent coaxialement dans des sens opposés d'écartement par rapport à un élément corps (1a), comprenant un moyen (17, 14, 13, 11) permettant de saisir le corps (1a) de la pièce électrique (1), des éléments de mise en forme (6) mutuellement séparés d'une distance légèrement supérieure à la longueur de l'élément corps (1a), et un moyen (5) qui produit un déplacement relatif entre la pièce électrique (1) et les éléments de mise en forme (6) de façon à fléchir les fils conducteurs dans la même direction et perpendiculairement à leur direction initiale, caractérisé en ce que les éléments de mise en forme (6) sont dotés de rainures (12) dans leurs parois intérieures afin de recevoir les fils conducteurs lorsque ceux-ci sont conduits à y entrer sous l'action dudit moyen (5), et en ce qu'un élément (13) de ladite paire d'éléments (11, 13) est conçu pour pouvoir être déplacé entre une première position, dans laquelle il coopère avec l'autre élément (11) pour saisir l'élément corps (1a) de la pièce électrique (1) et le retenir en empêchant son déplacement dans une direction (C) parallèle à la direction de déplacement relatif entre la pièce (1) et les éléments de mise en forme (6), et une deuxième position dans laquelle il ne retient pas l'élément corps (1a) et permet son déplacement dans ladite direction (C).

2. Appareil selon la revendication 1, où l'autre élément (11) de ladite paire d'éléments (11, 13) est conçu pour pouvoir être déplacé dans ladite direction (C).

3. Appareil selon la revendication 2, où l'autre élément (11) de ladite paire d'éléments (11, 13) est disposé sur l'extrémité d'un élément piston (5) qui est élastiquement sollicité par un ressort (19) à se déplacer dans ladite direction (C) lorsque ledit premier élément (13) de ladite paire d'éléments est déplacé jusqu'à sa deuxième position de manière à pousser la pièce électrique hors de l'appareil.

*FIG. 1*

*FIG. 2*

1

FIG. 3

FIG. 4

2

F I G . 5

F I G . 6

FIG. 7